# NEUE EUROPÄISCHE PATENTSCHRIFT

(11) **EP 0 755 321 B2**
(45) Veröffentlichungstag und Bekanntmachung des Hinweises auf die Entscheidung über den Einspruch: **17.09.2003**
(45) Hinweis auf die Patenterteilung: 19.11.1997
(21) Anmeldenummer: 95929059.4
(22) Anmeldetag: 02.08.1995
(51) Int. Cl.: B29C 67/00, G03C 9/08

(54) **VERFAHREN ZUR HERSTELLUNG EINES DREIDIMENSIONALEN OBJEKTES**
PROCESS FOR PRODUCING A THREE-DIMENSIONAL OBJECT
PROCEDE DE FABRICATION D'UN OBJET TRIDIMENSIONNEL

(30) Priorität: 16.09.1994 DE 4433118
(43) Veröffentlichungstag der Anmeldung: 29.01.1997
(73) Patentinhaber: EOS GmbH Electro Optical Systems, 82152 Krailling (DE)
(72) Erfinder: KELLER, Peter, D-82152 Martinsried (DE); WILKENING, Christian, D-86911 Diessen (DE); LANGER, Hans, J., D-82166 Gräfelfing (DE)
(74) Vertreter: Prüfer, Lutz H., Dipl.-Phys.
(86) Internationale Anmeldenummer: EP9503078
(87) Internationale Veröffentlichungsnummer: WO96008360

(56) Entgegenhaltungen:
- EP-A- 0 393 672
- WO-A-90/06540
- DE-A- 4 007 248
- US-A- 5 304 329
- KUNSTSTOF EN RUBBER, Bd. 44, Nr. 12, 1.Dezember 1992 ROTTERDAM NL, Seiten 14-18, XP 000327819 VISMAN R 'FAST PROTOTYPING MET 'SELECTIVE LASER SINTERING''
- MACHINE DESIGN, Bd. 62, Nr. 3, 8.Februar 1990 Seiten 127-132, XP 000102461 'MAKE IT IN A MINUTE : MACHINES THAT USE LASERS TO FORM MATERIALS MAY BE THE KEY TO QUICK, INEXPENSIVE PROTOTYPING'
- DATABASE WPI Section Ch, Week 9010 März 1990 Derwent Publications Ltd., London, GB; Class A32, AN 90-071252 & JP,A,02 024 127 (MITSUI ENG. & SHIPBUILDING) , 26.Januar 1990
- TECHNISCHE RUNDSCHAU, Bd. 83, Nr. 20, 17.Mai 1991 Seiten 36-41, 43, XP 000230938 SCHAETTI T 'RAPID PROTOTYPING ETABLIERT SICH . VERFAHREN ZUR SCHNELLEN FERTIGUNG VON MODELLEN UND MUSTERTEILEN'
- PATENT ABSTRACTS OF JAPAN vol. 10 no. 83 (M-466) ,2.April 1986 & JP,A,60 224568 (JIYANOME SEWING MACHINE KOGYO KK) 8.November 1985,
- Solid Freeform Fabrication Symposium Proceedings, August 6-8, 1990, Austin, Texas, USA, "Sintering Rates in the Selective Laser Sintering Process", Christian Nelson and J.W. Barlow, Department of Chemical Engineering, University of Texas at Austin, pp. 164-170
- Kunststoff Handbuch 3/2, Technische Polymer-Blends, Gerhard W. Becker und Dietrich Braun, Carl Hanser Verlag, München Wien, 1993, Seiten 2,3,12 und 13

## Beschreibung

Die Erfindung betrifft ein Verfahren zur Herstellung eines dreidimensionalen Objektes nach dem Oberbegriff des Patentanspruches 1.

Bei dem unter der Bezeichnung "Layermanufacturing" bekannten Verfahren wird ein dreidimensionales Objekt schichtweise durch Aufbringen und anschließendes Verfestigen aufeinanderfolgender Schichten eines zunächst flüssigen oder eines pulverförmigen Materials hergestellt. Die Verfestigung erfolgt dabei vorzugsweise durch einen gebündelten Lichtstrahl in Form eines Lasers oder dergleichen, der an die dem Objekt entsprechenden Stellen der Schicht gerichtet wird und dort die Verfestigung des Materials bewirkt. Ein Verfahren, bei dem ein pulverförmiges Feststoffmaterial als zu verfestigendes Medium verwendet wird, ist beispielsweise aus der US-A-4 863 538 bekannt.

Eine Vorrichtung zur Durchführung des Verfahrens mit flüssigem oder pulverförmigem Material ist aus der DE-A-41 34 265 bekannt.

Eine weitere Vorrichtung zur Durchführung des Verfahrens speziell mit pulverförmigem Material ist aus der DE-C-43 00 478 bekannt.

Um bestimmte Belichtungs- und Bauteileigenschaften zu erhalten, werden Mischungen verschiedener Pulver verwendet, wobei sich die einzelnen Pulver durch ihre thermischen Eigenschaften wie zum Beispiel die Schmelztemperatur und ihre rheologischen Eigenschaften wie zum Beispiel ihre Viskosität unterscheiden. Die Verwendung von Pulvermischungen hat jedoch die folgenden Nachteile:

In einer makroskopischen Pulvermischung weisen die einzelnen Pulverkörner jeweils die makroskopischen thermische bzw. rheologischen Eigenschaften eines jeweiligen Mischungsbestandteiles auf. Beim Erkalten nach der Belichtung einer Schicht mit dem Laserstrahl tritt in den Einzelbereichen (den Pulverkörnern) eine Kristallisation in Folge der Gleichförmigkeit und Regelmäßigkeit der Polymerketten auf, da unter der Belichtung keine vollständige Vermischung der Polymere auf molekularer Ebene stattfindet. Die Kristallisation führt zu einem Volumenschwund des Bauteiles, der im Prozentbereich liegen kann. Gerade dieser Volumenschwund stellt eines der größten Probleme beim Aufbau dreidimensionaler Modelle dar, da er nur durch aufwendige und exakte Temperaturführung gesteuert werden kann. Durch diese Temperaturführung kann jedoch allenfalls der Schwund von Einzelschichten verhindert werden. Beim Abkühlen des Gesamtbauteiles tritt er in jedem Fall auf. Der Kristallisationsgrad, d.h. der Anteil der kristallinen Bereiche am Gesamtvolumen, ist von der Abkühlgeschwindigkeit abhängig. Da die Abkühlgeschwindigkeit wiederum stark geometrieabhängig ist, sie unterscheidet sich z.B. stark für dünne Wände bzw. große gefüllte Volumina, stellt der Schwund durch Kristallisation immer einen unberechenbaren Faktor in der Bauteilgenauigkeit dar.

Ein weiterer Nachteil besteht darin, daß sich das Pulver beim Beschichtungsprozess bzw. bei der Verarbeitung oder Rückgewinnung entmischen kann oder sich das Mischverhältnis ändern kann. Die Gefahr der Entmischung besteht hauptsächlich bei Pulvermischungen, die sich durch Dichte, Kornform und Korngröße unterscheiden.

Ein weiterer Nachteil der Pulvergemische besteht darin, daß die Eigenschaften des späteren Bauteiles wie z.B. thermische und mechanische Kennwerte durch die schlechtere Komponente bestimmt sind.

Gemäß der Veröffentlichung W. Witt, Kunststoffe 74 (1984) 10; Seiten 592 - 595 ist ein Polymerblend eine thermoplastische Formmasse, die aus zwei oder mehreren Polymeren in jeweils höherprozentigen Anteilen (mindestens 10%) besteht, unter definierten Temperatur- und Scherbedingungen compoundiert wird und als verarbeitungsfertiges Granulat zum Einsatz kommt. Es unterscheidet sich dabei von einer Mischung von Polymeren dadurch, daß jedes Granulatkorn die selbe Zusammensetzung von Polymerbestandteilen aufweist und alle Granulatkörner untereinander gleiche Eigenschaften aufweisen. Eine pulverförmige Mischung aus Polymeren hingegen weist Pulverkörner auf, die aus verschiedenen Polymeren gebildet sind. Das bedeutet, nicht alle Pulverkömer haben die gleichen Eigenschaften.

Aus der US-A-5,076,869 ist ein Verfahren gemäß dem Oberbegriff des Anspruches 1 bekannt. Bei diesem Verfahren wird als Material eine pulverförmige Mischung aus Metallen, Keramiken und/oder Polymeren verwendet.

Aus der JP-A-02-024127 ist ein Verfahren gemäß dem Oberbegriff des Anspruches 1 bekannt, bei dem als Material ein flüssiges Harz verwendet wird, das eine Mischung aus einem wärmehärtenden und einem lichthärtenden Harz aufweist. Aus der EP 0 393 672 A2 ist ein Verfahren gemäß dem Oberbegriff des Anspruches 1 bekannt, bei dem als Material eine photohärtende, flüssige Mischung verwendet wird, die ein Additiv enthält, das in der Flüssigkeit löslich ist, aber sich beim Photohärten in eine separate Phase trennt.

Aus Technische Rundschau, Bd. 83, Nr. 20, 17. Mai 1991, Seiten 36 bis 43 ist ein Verfahren gemäß dem Oberbegriff des Anspruches 1 bekannt. Als Material wird ein Pulver verwendet. Aus der Machine Design, Bd. 62, Nr. 3, 8. Februar 1990, Seiten 127 bis 132 ist bekannt, bei einem Verfahren gemäß dem Oberbegriff des Anspruches 1 pulverförmige Polymere zu verwenden, wie z.B. ABS, Polyester, PVC, Nylon, Polypropylen und Polyurethan. Aus Kunststof en Rubber Bd. 44, Nr. 12, 1. Dezember 1992, Rotterdam, NL, Seiten 14 bis 18 ist bekannt, bei einem Verfahren gemäß dem Oberbegriff des Anspruches 1 Nylon, Polycarbonat und ABS/SAN als Material zu verwenden.

Aus der DE 40 07 248 A1 ist ein Verfahren zur Herstellung flexographischer Druckformen bekannt, das für photopolymerisierbare Druckplatten angewendet werden kann, die mindestens ein polymeres Bindemittel, mindestens eine durch aktinische Strahlung additionspolymerisierbare ethylenisch ungesättigte Verbindung und einen Photoinitiator oder ein Photoinitiatorsystem enthalten.

Aus der DE 43 05 201 C1 ist ein Verfahren gemäß dem Oberbegriff des Anspruches 1 bekannt, bei dem als Material eine Kombination aus verfestigbarem Kunststoffmaterial mit einem Füllmaterial in Form von Keramik- oder Metallpulver verwendet wird.

Aus der JP-A-60-224568 ist ein Verfahren zur Herstellung einer Druckplatte bekannt, bei dem ein Pulvermaterial kompaktiert und dann gesintert wird. Das Material besteht aus einer Mischung von Nylon mit hohem Schmelzpunkt, Nylon mit niedrigem Schmelzpunkt und Phlogopit.

Aus der US-A-5,304,329 ist ein Verfahren gemäß dem Oberbegriff des Anspruches 1 bekannt, bei dem als Material semikristalline Pulver verwendet werden, wie z.B. Nylon und Polybuthylen Terephthalat (PBT). Aus C. Nelson et al, Solid Freeform Fabrication Symposium Proceedings, Texas, 1990, S. 164-170 ist die Verwendungs einer Mischung aus PCL and SAA als Material zum Bestimmen der Sinterrate in Hinblick auf eine mögliche Anwendung für das Laserinterverfahren bekannt.

Aufgabe der Erfindung ist es, ein Verfahren zur Herstellung eines dreidimensionalen Objektes bereitzustellen, bei dem die Prozeßführung vereinfacht wird und gewünschte Eigenschaften des späteren Bauteiles schon im Ausgangsmaterial leicht einstellbar und variierbar sind.

Die Aufgabe wird gelöst durch ein Verfahren nach dem Patentanspruch 1. Weiterbildungen der Erfindung sind in den Unteransprüchen gegeben.

Ein Polymerblend ist eine Mischung auf molekularer Ebene von zwei oder mehr Polymeren bzw. Copolymeren. Die Vermischung geschieht in der Schmelze, aus welcher anschließend ein Pulver gewonnen wird. Somit enthält ein Pulverkorn verschiedene Polymere in vorgegebenem Mischungsverhältnis. Dies ist entscheidend für die Homogenität des späteren Bauteiles. Bei der mikroskopischen Mischung stellt sich eine neue Phase ein, welche die Eigenschaften der Mischungsbestandteile kombiniert und normalerweise Mittelwerte einnimmt. Daher ist es möglich, verschiedene Eigenschaftsprofile wie z.B. spröde-weich oder niederviskoshochviskos auf molekularer Ebene zu kombinieren. Größen wie die Glastemperatur, der Schubmodul und die Viskosität sind bei Polymerblends oft stufenlos einstellbar. Daher kann man gewünschte Eigenschaften des späteren Bauteiles schon im Ausgangsmaterial einstellen.

Da im Polymerblend unterschiedliche Kettenstrukturen auftreten, ist die Kristallisation stark behindert bzw. wird vollständig unterdrückt. Somit wird auch der Volumenschwund, der aus der Kristallisation folgt, verhindert. Bei einem amorphen Polymerblend enfällt dieser Volumenschwund komplett. Dadurch wird die Prozeßführung vereinfacht oder es sind bei identischem Prozeßaufwand genauere Modelle erzeugbar.

Weil das Polymerblend eine Mischung auf molekularer Ebene ist, kann sich bei der Verarbeitung des Pulvers oder der Rückgewinnung das Pulver nicht entmischen bzw. das. Mischverhältnis kann sich nicht ändern. Auch bei wiederverwendetem Pulver ist die Konstanz des Mischungsverhältnisses garantiert.

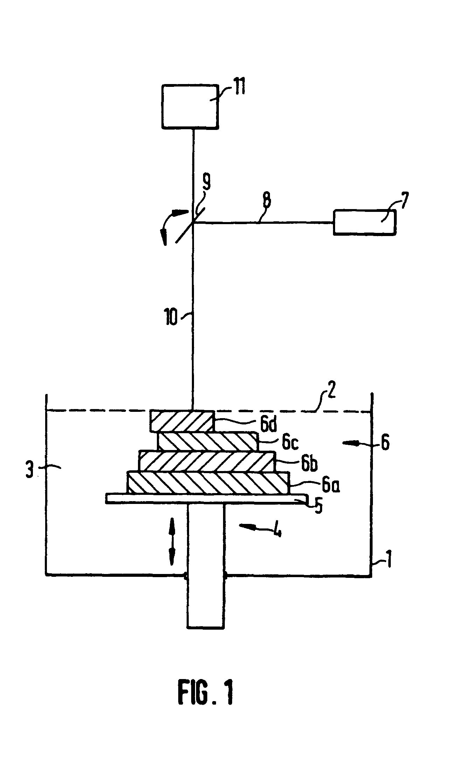

Weitere Merkmale und Zweckmäßigkeiten der Erfindung ergeben sich aus der Beschreibung eines Ausführungsbeispieles anhand der Figur.

Die Figur zeigt eine Vorrichtung zur Durchführung des erfindungsgemäßen Verfahrens.

Ein auf seiner Oberseite offener Behälter 1 ist bis zu einem Niveau bzw. einer Oberfläche 2 mit einem Polymerblend 3 in Pulverform gefüllt. Im Behälter 1 befindet sich im Bereich des Polymerblends 3 ein Träger 4 mit einer im wesentlichen ebenen und horizontalen Trägerplatte 5, die parallel zur Oberfläche 2 angeordnet ist und mittels einer nicht gezeigten Höheneinstellvorrichtung senkrecht zur Oberfläche 2 bzw. zur Trägerplatte 5 auf und ab verschoben und positioniert werden kann.

Auf der Trägerplatte 5 befindet sich das Objekt 6, das aus einer Mehrzahl von Schichten 6a, 6b, 6c und 6d, die sich jeweils parallel zur Oberfläche 2 und zur Trägerplatte 5 erstrecken, in der später beschriebenen Weise aufgebaut wird.

Über dem Behälter 1 befindet sich eine nicht gezeigte Vorrichtung zum Glätten der Oberfläche 2. Eine solche Vorrichtung kann beispielsweise als Walze oder als Wischer ausgebildet sein.

Oberhalb des Behälters 1 ist eine Bestrahlungseinrichtung 7 angeordnet, die einen gerichteten Lichtstrahl 8 abgibt. Bevorzugt besteht die Bestrahlungseinrichtung 7 aus einem Laser. Der gerichtete Lichtstrahl 8 wird über eine Ablenkeinrichtung 9, beispielsweise einen Drehspiegel, als abgelenkter Strahl 10 auf die Oberfläche 2 des Polymerblends 3 in dem Behälter 1 abgelenkt. Eine Steuerung 11 steuert die Ablenkeinrichtung 9 derart, daß der abgelenkte Strahl 10 auf jede gewünschte Stelle der Oberfläche 2 des Polymerblends 3 in dem Behälter 1 auftrifft.

Bei dem Verfahren zum Herstellen des dreidimensionalen Objektes wird die Trägerplatte 5 in einem ersten Schritt in dem Behälter so positioniert und das über der Trägerplatte 5 befindliche Material mit der nicht gezeigten Vorrichtung zum Gätten so geglättet, daß zwischen der Oberseite der Trägerplatte 5 und der Oberfläche 2 des Polymerblends 3 in dem Behälter 1 ein gerade der vorgesehenen Schichtdicke entsprechender Abstand vorliegt. Diese Schicht wird mittels des von dem Laser 7 erzeugten und über die Ablenkeinrichtung 9 und die Steuereinrichtung 11 gesteuerten Laserstrahles 8, 10 an vorgegebenen, dem Objekt entsprechenden Stellen bestrahlt, wodurch das Polymerblend 3 sintert und so eine der Form des Objektes entsprechende feste Schicht 6a bildet. Das Bilden von weiteren Schichten 6b, 6c und 6d erfolgt sukkzessive durch Absenken der Trägerplatte 5 um einen der jeweiligen Schichtdicke entsprechenden Betrag, Glätten der neu zu verfestigenden Schicht und Bestrahlen an den dem Objekt 6 entsprechenden Stellen.

Vorzugsweise werden gemäß der Erfindung die folgenden Polymerblends verwendet: Polyamid/Copolyamid, Polystyrol/Copolyamid, RPE/PA Blend (Polyphenylenether/Polyamid) z.B. Vestoblend, PPE/SB Blend (Polyphenylenether/Styrol/Butadienblend).

Durch Wahl des Mischungsverhältnisses der Polymerbestandteile in dem Polymerblend 3 können die mechanischen und/oder die thermischen Eigenschaften des Objekts (6) in werten Bereichen eingestellt werden.

## Patentansprüche

1. Verfahren zur Herstellung eines dreidimensionalen Objektes, bei dem aufeinanderfolgende Schichten (6a, 6b, 6c, 6d) des zu bildenden Objektes (2) aus mittels elektromagnetischer Strahlung verfestigbarem Material nacheinander durch Einwirkung einer elektromagnetischen Strahlung (8, 10) verfestigt werden,
**dadurch gekennzeichnet, daß**
als Material ein Polymerblend, das eim Mischung aus verschiedenen Polymeren bzw. Copolymeren any molekularer Elene ist, verwendet wird, wobei das Polymerblend in Pulverform verwendet wird und jedes Pulverkorn des Pulvers die verschiedenen Polymere in einem vorgegebenen Mischungsverhältnis enthält, wobei
das Polymerblend erhalten wird durch Mischen von den verschiedenen Polymeren in der Schmelze und anschließendem Gewinnen des Pulvers aus der Schmelze.

2. Verfahren nach Anspruch 1 **dadurch gekennzeichnet,**
**daß** das Polymerblend Polyamid und Copolyamid umfaßt.

3. Verfahren nach Anspruch 1 **dadurch gekennzeichnet,**
**daß** das Polymerblend Polystyrol und Copolyamid umfaßt.

4. Verfahren nach Anspruch 1 , **dadurch gekennzeichnet,**
**daß** das Polymerblend Polyphenylether und Polyamid umfaßt.

5. Verfahren nach Anspruch 1 , **dadurch gekennzeichnet,**
**daß** das Polymerblend Styrol und Butadien umfaßt.

6. Verfahren nach Anspruch 5, **dadurch gekennzeichnet,**
**daß** das Polymerblend Polyphenylether umfaßt.

7. Verfahren nach einem der Ansprüche 1 bis 6,
**dadurch gekennzeichnet,**
**daß** die elektromagnetische Strahlung Laserstrahlung (8, 9) ist.

## Claims

1. Process for producing a three-dimensional object, in which sequential layers (6a, 6b, 6c, 6d) of the object (2) to be formed, which are composed of material that can be solidified by means of electromagnetic radiation, are solidified one after the other by the action of electromagnetic radiation (8, 10), **characterized in that** the material used is a polymer blend, which is a mixture of various polymers or copolymers at molecular level, the polymer blend being used in powder form and each powder grain of the powder containing the various polymers in a predetermined mixing ratio, the polymer blend being obtained by mixing the various polymers in the melt and then obtaining the powder from the melt.

2. Process according to Claim 1, **characterized in that** the polymer blend comprises polyamide and copolyamide.

3. Process according to Claim 1, **characterized in that** the polymer blend comprises polystyrene and copolyamide.

4. Process according to Claim 1, **characterized in that** the polymer blend comprises polyphenyl ether and polyamide.

5. Process according to Claim 1, **characterized in that** the polymer blend comprises styrene and butadiene.

6. Process according to Claim 5, **characterized in that** the polymer blend comprises polyphenyl ether.

7. Process according to one of Claims 1 to 6, **characterized in that** the electromagnetic radiation is laser radiation (8, 9).

## Revendications

1. Procédé pour la préparation d'un objet tridimensionnel, dans lequel des couches consécutives (6a, 6b, 6c, 6d) de l'objet (2) à former à partir d'un matériau durcissable au moyen d'un rayonnement électromagnétique sont solidifiées successivement par action d'un rayonnement électromagnétique (8, 10), **caractérisé en ce qu'**on utilise comme matériau un ensemble de polymères, qui est un mélange de plusieurs polymères ou de copolymères au niveau moléculaire, l'ensemble de polymères étant utilisé sous forme de poudre et chaque particule de poudre contenant les différents polymères dans un rapport de mélange prédéfini, l'ensemble de polymères étant obtenu par mélange des différents polymères dans la masse fondue et production de la poudre à partir de la masse fondue.

2. Procédé selon la revendication 1, **caractérisé en ce que** le mélange de polymères comprend un polyamide et un copolyamide.

3. Procédé selon la revendication 1, **caractérisé en ce que** le mélange de polymères comprend un polystyrène et un copolyamide.

4. Procédé selon la revendication 1, **caractérisé en ce que** le mélange de polymères contient un polyphényl-éther et un polyamide.

5. Procédé selon la revendication 1, **caractérisé en ce que** le mélange de polymères comprend du styrène et du butadiène.

6. Procédé selon la revendication 5, **caractérisé en ce que** le mélange de polymères comprend un polyphényl-éther.

7. Procédé selon l'une des revendications 1 à 6, **caractérisé en ce que** le rayonnement électromagnétique est un rayonnement laser (8, 9).
